# EUROPEAN PATENT APPLICATION

(11) **EP 1 689 197 A1**
(43) Date of publication of application: **09.08.2006**
(21) Application number: 06250311.5
(22) Date of filing: 20.01.2006
(51) Int. Cl.: H04N 9/28

(54) **A method of displaying video during auto-convergence**

(30) Priority: 07.02.2005 KR 2005011342
(71) Applicant: LG Electronics Inc., Yongdungpo-gu Seoul (KR)
(72) Inventor: Choi, Heung Gyeng, Gyeongsangbuk-do (KR)
(74) Representative: Camp, Ronald

(57) **Abstract**

A method of executing auto convergence in a display device includes measuring brightness of ambient light, displaying a picture in a display window (130) of a projection television screen if the brightness of the measured ambient light is within a preset limit, and executing auto convergence while displaying the picture in the display window. Auto convergence may make use of a region of the screen (110) outside the display window. If the display window is of a size which would adversely affect the convergence, then it can be reduced to a size where it does not affect the convergence process.

## Description

The present invention relates to a method of displaying video. It more particularly relates to a method of displaying video during auto-convergence.

In general, a projection television (TV) comprises a cathode ray tube (CRT) having three colors, namely, red, green, and blue (RGB). In operation, the CRT shoots a beam of light through an optical unit comprised of a plurality of reflecting mirrors and lenses. The beam of light is then magnified and projected on a large screen of the projection TV.

The quality of sensitivity of the projection TV is comprised of various categories such as white uniformity (W/U), bright uniformity (B/U), convergence, focus, distortion. The description of the convergence is as follows. The convergence refers to converging of the RGB beams shot from an electron gun to a point on a screen as a result of a magnetic field of the deflecting yoke. On the contrary, if there is a defect in the deflecting yoke or the light is deflected improperly, misconvergence occurs resulting in a color bias on the screen.

That is, the RGB beams have to accurately focus at a point on a screen in order for white light to be visible. However, with misconvergence, lines represented by colors other than the RGB colors are displayed, negatively affecting the quality of the visual screen. In other words, it is important to focus the RGB beams shot from the CRT at a single point.

Here, focusing of the RGB beams to a single point is called auto convergence. With the advent of digital broadcasting, projection TVs are in the spotlight as the display to satisfy the demands for large screen televisions. However, projection TVs are not without flaws. A disadvantage of projection TV is that, a user has to execute convergence of the RGB beams because the projection TV comprises individual CRTs corresponding to each RGB color. The reason for this is that with the increasing number of viewing hours, the converged RGB beams can loose convergence. Without executing convergence, the clarity or distinction of colors on the screen displaying a video can be inaccurate.

To fix such problems of misconvergence, a projection TV includes a convergence correction unit for controlling beams so that the video outputted from each light transmitter is accurately displayed on the screen. Generally, projection TVs packaged for sale have gone through extensive testing, including convergence; however, once a TV having corrected convergence is viewed at home by a user, factors such as change in environment or magnetic fields from other electronic devices cause errors in convergence in TVs. Therefore, the convergence correcting device can be used in homes to correct errors in convergence.

The following figures are used to explain auto convergence of projection TVs in detail.

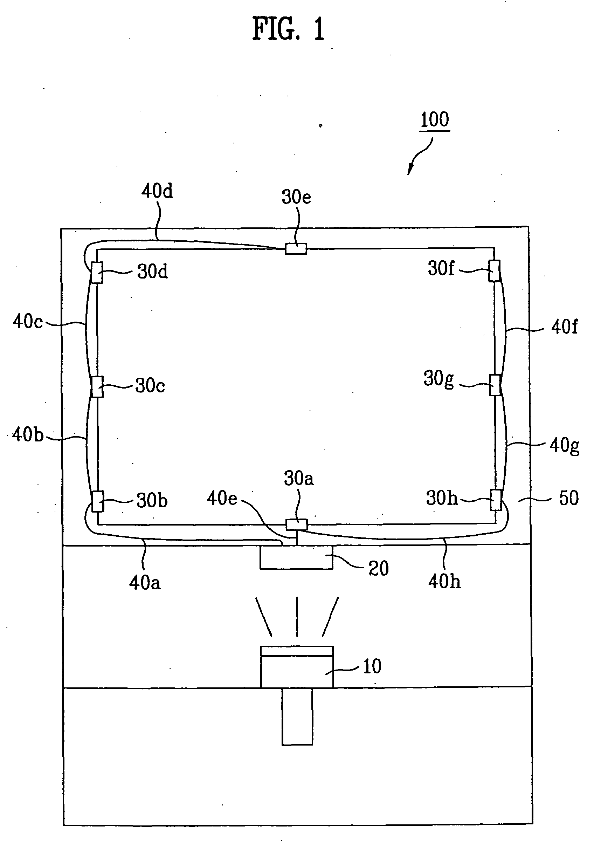

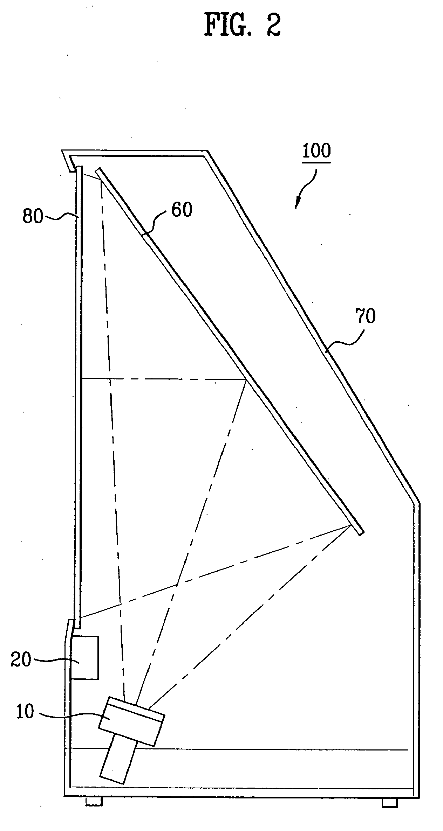

Figure 1 is an example illustrating auto convergence of a projection TV. Furthermore, Figure 2 is a side view of a projection TV. The projection TV 100 of Figures 1 and 2 is comprised of a projector 10, an auto convergence unit 20, a light sensor 30, a connector 40, a cabinet 50, a mirror 60, a case 70, and a screen 80.

In operation, the projector 10 emits video to the screen 80 after the video has been deflected by the mirror 60. The auto convergence unit 20, according to the control signals, generates RGB signal patterns for executing auto convergence, and thereafter executes auto convergence after the RGB signal patterns have been detected by the light sensor 30.

The light sensors 30 (30a - 30h) are placed behind the screen 80, where they are hidden from the view of the consumer, to detect the pattern signals of the RGB signals. In addition, the connector 40 (40a - 40h) are signal lines for the transmission of detected signals from the light sensor 30 to the auto convergence unit 20. Moreover, the cabinet 50 operatively connects the light sensor 30 and the connector 40. The mirror 60 reflects the video outputted from the projector 10 to the screen 80. Here, the screen 80 display the video which has been reflected by the mirror 60 on the screen 80.

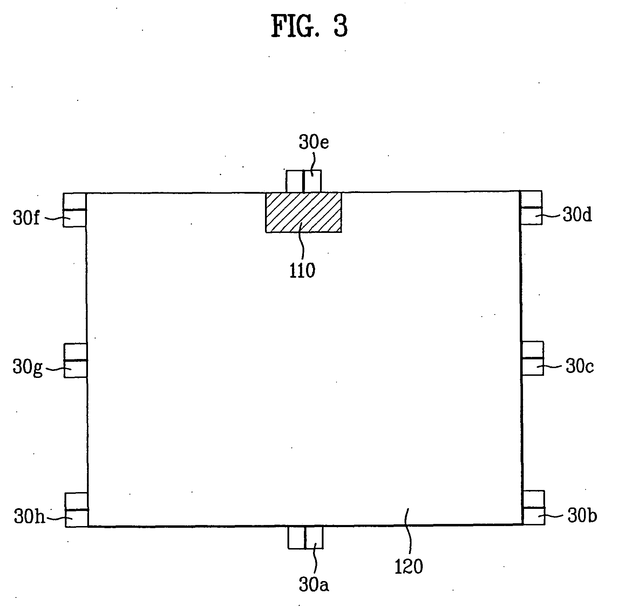

Figure 3 illustrates the screen of the projection TV. According to the conventional operation of the projection TV, an auto convergence pattern area 110 is displayed in a specified area of the display area 120. Thereafter, the light sensor 30 measures the auto convergence pattern area 110, and according to the measured pattern, auto convergence is executed.

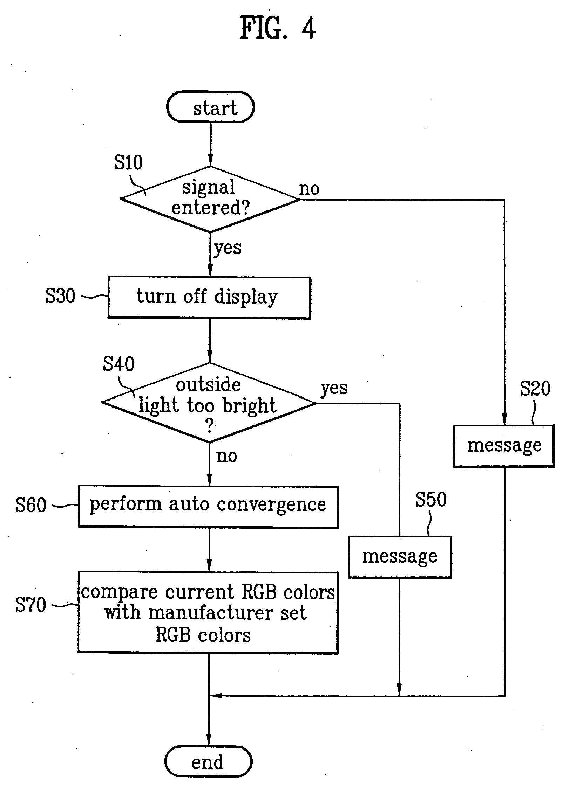

Figure 4 is a flow chart illustrating a method of executing auto convergence in a projection TV. The projection TV determines whether user has entered a command signal (e.g., using a remote controller) to order auto convergence after turning on the power to the projection TV (S10). After determining that the command signal has not been inputted, the projection TV displays a message on the display area to re-enter the command signal for auto convergence (S20).

After determining that the command signal for auto convergence has been properly entered, the video currently viewed is blocked from being displayed or the screen is turned off in order to execute auto convergence (S30). Next, the projection TV determines whether the brightness of the outside or ambient light is appropriate to execute auto convergence (S40). This step is necessary to prevent error while executing auto convergence.

After determining that the ambient light is too bright for auto convergence, the projection TV provides a instruction message on the display area requesting the user to lower or dim the lighting and re-enter the auto convergence command signal (S50). However, if the light sensor determines that the brightness of the ambient light is appropriate for executing auto convergence, a color correction with respect to each of the RGB colors is executed (S60). Thereafter, the factory set RGB color levels are used as reference to executing auto convergence (S70).

As explained above with respect to conventional projection TVs, executing auto convergence involves emitting only the signal light (signal pattern), and not the video, to prevent errors by the light sensor. To accomplish this, the video that was being displayed on the display area is turned off (or muted). Consequently, a viewer cannot view the video or the current programming during auto convergence execution.

The present invention seeks to provide an improved method and apparatus for executing auto convergence.

A first aspect of the invention provides a method of executing auto convergence in a display device, the method comprising: measuring brightness of ambient light; displaying a picture in a display window of a projection television screen if the brightness of the measured ambient light is within a preset limit; and executing auto convergence while displaying the picture in the display window.

Another aspect of the invention provides a method of executing auto convergence in a projection television, the method comprising: receiving a command signal to execute auto convergence while displaying a picture on a screen of the television; turning off display of picture on the screen after receiving the command signal; measuring brightness of ambient light after the display of picture is turned off; displaying the picture in a display window of the screen if the brightness of the ambient light is within a preset limit; and executing auto convergence while displaying the picture in the display window.

Another aspect of the invention provides a display device for executing auto convergence, the device comprising: a light sensor arranged to measure brightness of ambient light; a display window of a projection television screen arranged to display a picture, wherein the picture is displayed if the measured brightness of the ambient light is within a preset limit; and a micro computer arranged to execute auto convergence while displaying the picture in the display window.

Embodiments of the invention will now be described by way of non-limiting example only, with reference to the drawings, in which:
FIG. 1 is an example illustrating auto convergence of a projection television;
FIG. 2 a side view of a projection television;
FIG. 3. illustrates a screen of the projection television;
FIG. 4 is a flow chart illustrating a method of executing auto convergence in a projection television;
FIG. 5 is an example illustrating execution of auto convergence in a projection television according to the present invention;
FIG. 6 is a flowchart illustrating an example of executing auto convergence according to an embodiment of the present invention;
FIG. 7 is a flowchart illustrating an example of executing auto convergence according to another embodiment of the present invention;
FIG. 8 is an example of a block diagram illustrating a structure of a projection television

Reference will now be made in detail to the embodiments of the invention, which are illustrated in the drawings. Wherever possible, the same reference numbers will be used throughout the drawings to refer to the same or like parts.

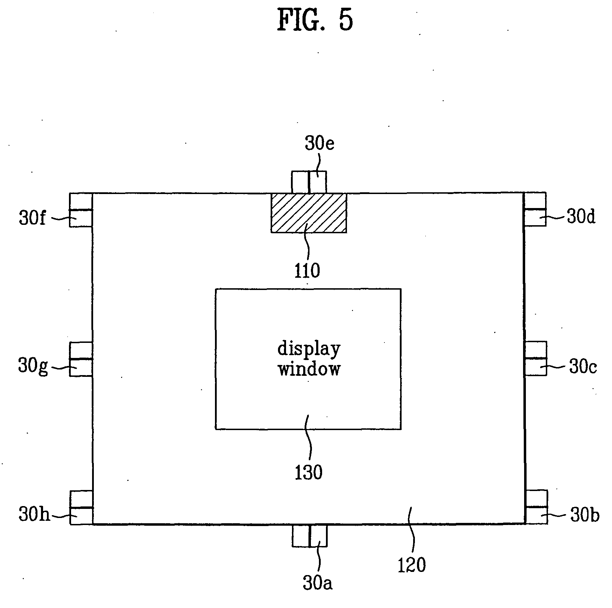

Figure 5 is an example illustrating execution of auto convergence in a projection TV. In Figure 5, a signal pattern in an auto convergence can be displayed in a signal pattern area 110 of the display area 120 when executing auto convergence in the projection TV. Then the light sensor 30 measures the signal pattern area 110, and after which executes auto convergence according to the measured signal pattern.

In the present embodiment, when executing auto convergence, the video currently being viewed can be displayed in a display window 130 of the display area 120 in a form of picture-in-picture (PEP) or picture-on-picture (POP), for example. Here, the size of the display window 130 is smaller than the size of the display area 120. Furthermore, the size and location of the specified area 130 can be controlled. More specifically, the size of the display window 130 (e.g., PIP or POP) can be up to approximately 3/4 the size of the display area 130. At the same time, the location of the display window 130 (e.g., PIP or POP) should be located on the display area 120 so as to not affect the output measurement voltage from the specified pattern area of the signal pattern when auto convergence is being executed.

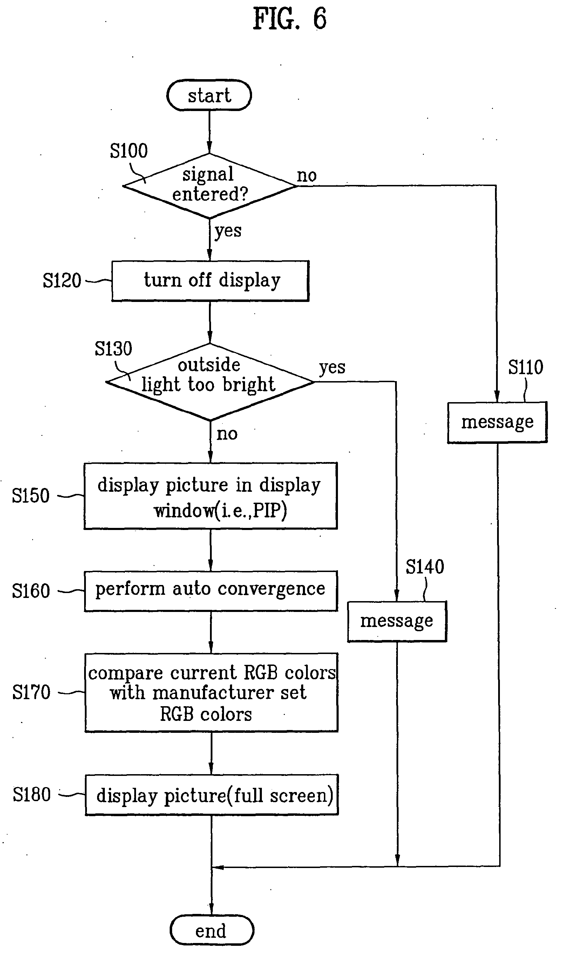

In Figure 6, a flowchart illustrating an example of executing auto convergence, the projection TV determines whether a command signal for executing auto convergence has been entered via an input device (e.g., a remote controller) after the power to the projection is turned on (S100). Here, the command signal can be inputted with the assistance of an input device or can be inputted directly to the projection TV. After determining that a command signal has not been entered, an instruction message is displayed on the display area of the projection TV requesting the viewer or user to re-enter the command signal for executing auto convergence (S110).

Alternatively, if the command signal for executing auto convergence was recognized by the projection TV, the picture or video currently being viewed on the display area is turned off or not displayed (S120). Thereafter, the outside or ambient light surrounding the projection TV is measured to determine whether the brightness is appropriate for executing auto convergence (S130). The reason for determining the ambient light brightness is to accurately measure and prevent errors in executing auto convergence.

After measuring the ambient light, if it is determined that the ambient light exceeds the permitted brightness level or a reference brightness set by the manufacturer, an instruction message is displayed on the display area of the projection TV requesting the user or viewer to dim or lower the ambient brightness and re-enter the command signal for executing auto convergence (S140).

However, if the ambient light is determined appropriate for executing auto convergence, the picture or video currently being viewed is displayed on the display window (e.g., PIP) on display area 120 of the projection TV (S150). Next, auto convergence, which includes color correction of RGB colors, is performed (S160). Thereafter, the RGB colors set by the manufacturer is compared to the current current RGB colors (S170). Lastly, after completion of auto convergence, the display on the display window (e.g., PIP) is displayed on the full screen (S180).

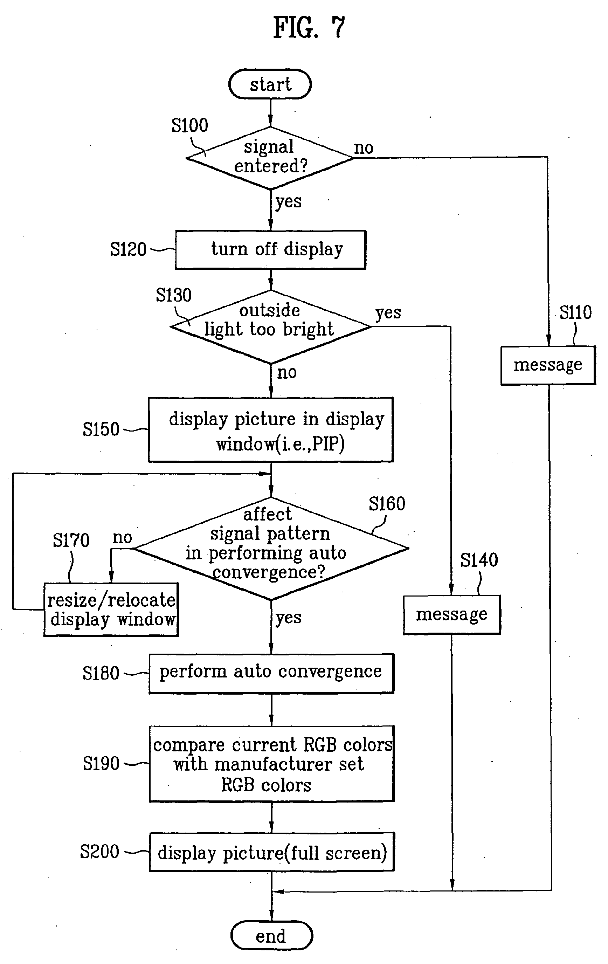

In Figure 7, a flowchart illustrating another example of executing auto convergence, the projection TV determines whether a command signal for executing auto convergence has been entered via an input device (e.g., a remote controller) after the power to the projection is turned on (S100). After determining that a command signal has not been entered, an instruction message is displayed in the display area 120 of the projection TV requesting the viewer or user to re-enter the command signal for executing auto convergence (S110). However, the instruction message is not limited to display. The message can be provided via a speaker requesting the user to re-enter the command signal.

Alternatively, if the command signal for executing auto convergence was recognized by the projection TV, the picture or video currently being viewed on the display area is turned off or not displayed (S120). Thereafter, the outside or ambient light surrounding the projection TV is measured to determine whether the brightness is appropriate for executing auto convergence (S130). The reason for determining the ambient light brightness is to accurately measure and prevent errors in executing auto convergence.

After measuring the ambient light, if it is determined that the ambient light exceeds the permitted brightness level or a reference brightness set by the manufacturer, an instruction message is displayed on the display area of the projection TV requesting the user or viewer to dim or lower the ambient brightness and re-enter the command signal for executing auto convergence (S140). As mentioned above, the instruction message can be an audio instruction delivered via a speaker.

However, if the ambient light is determined appropriate for executing auto convergence, the picture or video currently being viewed is displayed on the display window (e.g., PIP) on display area 120 of the projection TV (S150). Before executing auto convergence, a determination is made as to whether the display on the display window 130 (e.g., PIP) affects the signal pattern in executing auto convergence (S160). Here, if it is determined that the display affects the signal pattern area 110 for executing auto convergence, the size and/or the location of the display window 130 is resized and/or relocated so as not to affect execution of auto convergence (S170). However, if it determined that the display on the display window 130 does not affect the signal pattern area 110, auto convergence is executed (S 180).

Thereafter, the RGB colors at the time of auto convergence are compared to the RGB colors preset by the manufacturer (S190). Lastly, after completion of auto convergence, the display on the display window (e.g., PIP) is displayed on the full screen (S200).

As discussed above, the size of the display window 130 can be adjusted or resized. By default, the size of the display window can be 1/2 or 2/3 size of the display area 120. However, the size does not have to be restricted. The size of the display window 130 can be expanded to a size that does not affect the signal pattern area 110 in executing auto convergence. In other words, if the display window is displaying a picture or video, the signal indirectly emitted from the specific display area 130 should not be too close so as to affect the pattern area 110 in executing auto convergence.

In addition, a maximum size or boundary of the display window 130 can be set by the manufacturer of the projection TV. It is likely that the manufacturer has undergone series of field testing to determine the appropriate or acceptable maximum size or boundary from which the specific display area size can be adjusted without affecting the signal pattern 110. Therefore, the size of the display window 130 can be adjusted within the boundary established by manufacturer.

Furthermore, the size of the specific display area 130 can be adjusted automatically. More specifically, the size can be automatically downward adjusted. That is, if the size of the specific display area 130 is determined to affect (or too close to) the signal pattern area 110 during execution of auto convergence, the size of the specific display area 130 would be automatically reduced to a size that does not affect the signal pattern area 110. Again, the reduction or the downward adjustment would be preset in the projection TV by the manufacturer using a certain algorithm.

In addition to adjusting the size of the specific display area 130, relocating the display window 130 within the display area 120 is also possible. Similar to the discussion of above with respect to the size adjustment, a boundary can be set within which the display window 130 can be located. Again, it is likely that the manufacturer has undergone series of field testing to determine the appropriate or acceptable maximum size or boundary from which the display window size can be relocated without affecting the signal pattern area 110. As such, the display window 130 can be positioned anywhere within the boundary established by manufacturer.

Another example of relocating the display window 130 relates to relocating the display window 130 anywhere in the display area 120. To accomplish this, the display window 130 has to be safely distanced from the signal pattern area 110 so as not to affect execution of auto convergence. For example, if auto convergence is being performed in the signal pattern area on top of the display area, the display window 130 can be relocated to slightly below the signal pattern area 110 without affecting the signal pattern or to the bottom of the display area 120 to be safe. Here, the minimum safe distance can be preset or predetermined by the manufacturer.

Additionally, if it is determined that the display window 130 does affect the signal pattern area 110, the display window 130 can be relocated to the opposite side or opposing end of the signal pattern area executing auto convergence. For example, if the signal pattern area 110 on top of display area is executing auto convergence, the display window can be relocated to the bottom of the screen, safely away from the signal pattern area executing auto convergence.

The discussion above regarding size adjustment and relocation of display window is not limited to the discussion of above. Adjusting and relocating of display window size can take place according to any combination of the discussion above. For example, the display window 130 can be relocated and size adjusted at the same time.

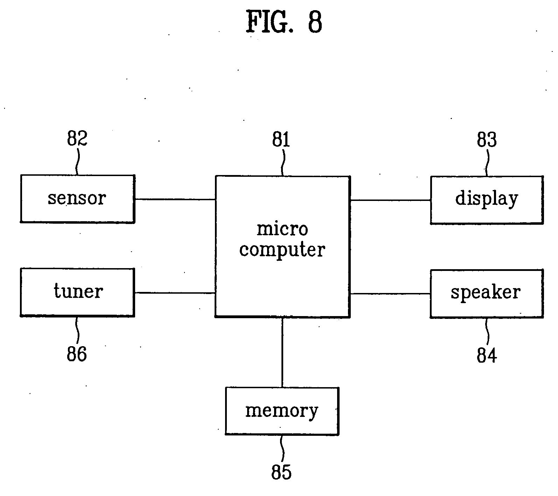

In Figure 8, an example of a block diagram illustrating a structure of a projection television, a micro computer 81 controls executing auto convergence. To execute auto convergence, as discussed above, the sensor 82 measures brightness of the ambient light. The measured brightness is compared with a permitted or maximum brightness level. The permitted brightness level is set by the manufacturer at the time the projection TV was manufactured and stored in the memory 85. After comparing, if the micro computer 81 determines that the measured brightness does not exceed the permitted level, a display window 83 is provided. Before executing auto convergence, the micro computer 81 determines whether the size and/or location of the display window affect the signal pattern area. If it is determined that the size and/or location affect the signal pattern area, then the micro computer resizes and/or relocates the display window 83. Thereafter, the micro computer executes auto convergence.

It will be apparent to those skilled in the art that various modifications and variations can be made to the embodiments of the present invention without departing from the scope thereof. Thus, it is intended that the present invention covers the modifications and variations of this invention provided they come within the scope of the claims and their equivalents.

## Claims

1. A method of executing auto convergence in a display device, the method comprising:
measuring brightness of ambient light;
displaying a picture in a display window of a projection television screen if the brightness of the measured ambient light is within a preset limit; and
executing auto convergence while displaying the picture in the display window.

2. The method of claim 1, wherein the brightness of the ambient light is measured by at least one light sensor located on the projection television.

3. The method of claim 1, wherein the preset limit is set by a manufacturer of the projection television.

4. The method of claim 3, wherein the preset limit is a maximum level of brightness permitted for executing auto convergence.

5. The method of claim 1, wherein the display window on the screen is a picture-in-picture (PIP) or a picture-on-picture (POP).

6. The method of claim 1, wherein the picture is a video.

7. The method of claim 1, wherein the picture is a still image.

8. The method of claim 1, wherein the display device is a projection television.

9. A method of executing auto convergence in a projection television, the method comprising:
receiving a command signal to execute auto convergence while displaying a picture on a screen of the television;
turning off display of picture on the screen after receiving the command signal;
measuring brightness of ambient light after the display of picture is turned off;
displaying the picture in a display window of the screen if the brightness of the ambient light is within a preset limit; and
executing auto convergence while displaying the picture in the display window.

10. The method of claim 9, wherein the command signal is received via a remote controller.

11. The method of claim 10, wherein the remote controller includes a mobile handset, a wireless telephone, a personal digital assistant, a handheld computer, a wireless keyboard, a wired keyboard, a notebook computer, a television remote control unit, or a desktop computer.

12. The method of claim 9, wherein the command signal is received via a control button on the projection television.

13. The method of claim 9, wherein the brightness of the ambient light is measured by at least one light sensor located on the projection television.

14. The method of claim 9, wherein the preset limit is set by a manufacturer of the projection television.

15. The method of claim 9, further comprising displaying a message on the screen requesting a user to re-enter the command signal if the ambient light is outside the preset limit.

16. The method of claim 15, wherein the preset limit is set by a manufacturer of the projection television.

17. The method of claim 9, wherein the display window on the screen is a picture-in-picture (PIP) or a picture-on-picture (POP).

18. The method of claim 9, wherein the display window is located in a center of the screen.

19. The method of claim 18, wherein a size of the display window is adjustable within a preset boundary.

20. The method of claim 19, wherein the preset boundary includes a maximum size in which the picture can be displayed without affecting measurement of signal pattern during execution of auto convergence.

21. The method of claim 9, wherein the display window is located anywhere on the projection television screen safely distanced from a signal pattern area of a light sensor.

22. The method of claim 21, wherein the display window is located safely away from the signal pattern area executing auto convergence.

23. The method of claim 21, wherein the display window is a moving picture-in-picture (PIP) or a picture-on-picture (POP).

24. The method of claim 21, wherein a size of the display window is adjustable to any size, and in which the size does not affect measuring of signal patterns during execution of auto convergence.

25. The method of claim 9, wherein executing auto convergence includes converging red, green, and blue beams emitted from a cathode ray tube (CRT) to a specific point on the projection television screen.

26. The method of claim 9, further comprising determining whether displaying a picture in the display window affects the signal pattern for executing auto convergence.

27. The method of claim 26, wherein the size of the display window is downwardly adjusted if displaying of a picture in the specific display area affects the signal pattern for executing auto convergence beyond an affect threshold set by a projection television manufacturer.

28. The method of claim 27, wherein the affect threshold is a maximum signal output from the picture displayed in the display window without affecting measurement of signal pattern for execution of auto convergence.

29. The method of claim 27, wherein the maximum size of the specified display is a size where the size does not affect the measurement of the signal pattern during execution of auto convergence.

30. The method of claim 27, wherein the size of the display window is automatically downwardly adjusted by the projection television if displaying of picture in the specific display area affects the signal pattern for executing auto convergence.

31. The method of claim 26, wherein the display window is re-located if the effect of the picture displayed in the specific display area exceeds an affect threshold set by the projection television manufacturer.

32. The method of claim 31, wherein the affect threshold is a maximum signal output from the picture displayed in the display window without affecting the measurement of the signal pattern for execution of auto convergence.

33. The method of claim 31, wherein the display window is located anywhere on the projection television screen safely distanced from a signal pattern area.

34. The method of claim 31, wherein the display window is automatically relocated within the projection television screen safely away from the signal pattern area executing auto convergence.

35. The method of claim 31, wherein the specified area automatically relocates on an opposite end from the signal pattern area executing auto convergence.

36. The method of claim 9, wherein the picture is a video.

37. The method of claim 9, wherein the picture is a still image.

38. A display device for executing auto convergence, the device comprising:
a light sensor arranged to measure brightness of ambient light;
a display window of a projection television screen arranged to display a picture, wherein the picture is displayed if the measured brightness of the ambient light is within a preset limit; and
a micro computer arranged to execute auto convergence while displaying the picture in the display window.

39. The device of claim 38, wherein the display device is a projection television.

40. The device of claim 38, wherein the micro computer is arranged to compare the measured brightness of ambient light with a maximum brightness level set by a manufacturer.

41. The method of claim 38, wherein the preset limit is a maximum level of brightness permitted for executing auto convergence.
